# EUROPÄISCHE PATENTSCHRIFT

(11) **EP 3 308 410 B1**
(45) Veröffentlichungstag und Bekanntmachung des Hinweises auf die Patenterteilung: **04.03.2020**
(21) Anmeldenummer: 16716540.6
(22) Anmeldetag: 13.04.2016
(51) Int. Cl.: H01L 41/053, B24C 1/00, H01L 41/083, H01L 41/22, H01L 41/27, B24C 3/32

(54) **VERFAHREN ZUR HERSTELLUNG EINES PIEZOELEKTRISCHEN SCHICHTSTAPELS SOWIE PIEZOELEKTRISCHER SCHICHTSTAPEL**
METHOD FOR THE PRODUCTION OF A PIEZOELECTRIC LAYER STACK, AND PIEZOELECTRIC LAYER STACK
PROCÉDÉ DE FABRICATION D'UN EMPILEMENT DE COUCHES PIÉZOÉLECTRIQUE ET EMPILEMENT DE COUCHES PIÉZOÉLECTRIQUE

(30) Priorität: 12.06.2015 DE 102015210797
(43) Veröffentlichungstag der Anmeldung: 18.04.2018
(73) Patentinhaber: Vitesco Technologies GmbH, 30165 Hannover (DE)
(72) Erfinder: ZUMSTRULL, Claus, 93128 Regenstauf (DE); WILDGEN, Andreas, 93047 Regensburg (DE)
(74) Vertreter: Waldmann, Georg Alexander
(86) Internationale Anmeldenummer: PCT/EP2016/058097
(87) Internationale Veröffentlichungsnummer: WO 2016/198183

(56) Entgegenhaltungen:
- EP-A1- 2 472 619
- DE-A1-102013 104 621
- US-A1- 2003 164 660
- US-A1- 2006 124 156

## Beschreibung

Die Erfindung betrifft ein Verfahren zur Herstellung eines piezoelektrischen Schichtstapels gemäß Anspruch 1 sowie einen piezoelektrischen Schichtstapel gemäß Anspruch 7, der insbesondere mit einem solchen Verfahren hergestellt worden ist.

Piezoelektrische Schichtstapel werden als elektronische Bauelemente beispielsweise in Aktuatoreinheiten zum Einspritzen von Kraftstoffen in einen Brennraum eines Zylinders einer Verbrennungskraftmaschine verwendet.

Die als beispielsweise Aktuatoreinheit verwendeten Schichtstapel weisen typischerweise eine Mehrzahl an piezoelektrischen Keramikschichten und eine Mehrzahl an elektrisch leitfähigen Innenelektroden auf, wobei jeweils eine der Innenelektroden zwischen zwei piezoelektrischen Keramikschichten angeordnet ist. Besonders häufig werden als elektronische Bauelemente ausgebildete Schichtstapel in Form von Piezoaktoren verwendet, um als Betätigungselement in Einspritzventilen der verschiedensten Motortypen für Kraftfahrzeuge zur Anwendung zu kommen.

Mit zunehmender Anforderung an Emission und Verbrauch steigen auch die Anforderungen an die Einspritzung des Kraftstoffes in den Brennraum. Höhere Drücke, Temperaturen, sowie Mehrfacheinspritzungen erfordern demzufolge eine höhere Genauigkeit bei der Zumessung des eingespritzten Kraftstoffes. Dabei geht der Trend zu höheren elektrischen Feldstärken und höheren Laufzeitanforderungen. Dabei steigt die Gefahr von elektrischen Überschlägen an der Oberfläche des Schichtstapels.
Die Gefahr elektrischer Überschläge an der Oberfläche des Schichtstapels erhöht sich dabei dadurch, dass beispielsweise durch Schleifprozesse des Schichtstapels typischerweise die oberste Kornschicht mechanisch beschädigt wird, wobei sich das lose Kornmaterial jedoch nicht aus dem gesinterten Keramikverband löst. Dadurch entsteht eine lose Kornschicht, die nur mechanisch mit dem keramischen Kristallkörper verbunden ist. Diese lose Kornschicht bildet unter mechanischer und thermomechanischer Belastung die Basis für Degradationserscheingungen der Keramik sowie einen leitfähigen Pfad im ansonsten hochohmigen Keramikmaterial. Denn durch die lose Kornschicht bilden sich Mikrorisse an der Oberfläche des Schichtstapels aus, in die Feuchtigkeit und/oder Metallionen migrieren und so einen elektrischen Leitpfad zwischen zwei benachbarten Innenelektroden bilden können.

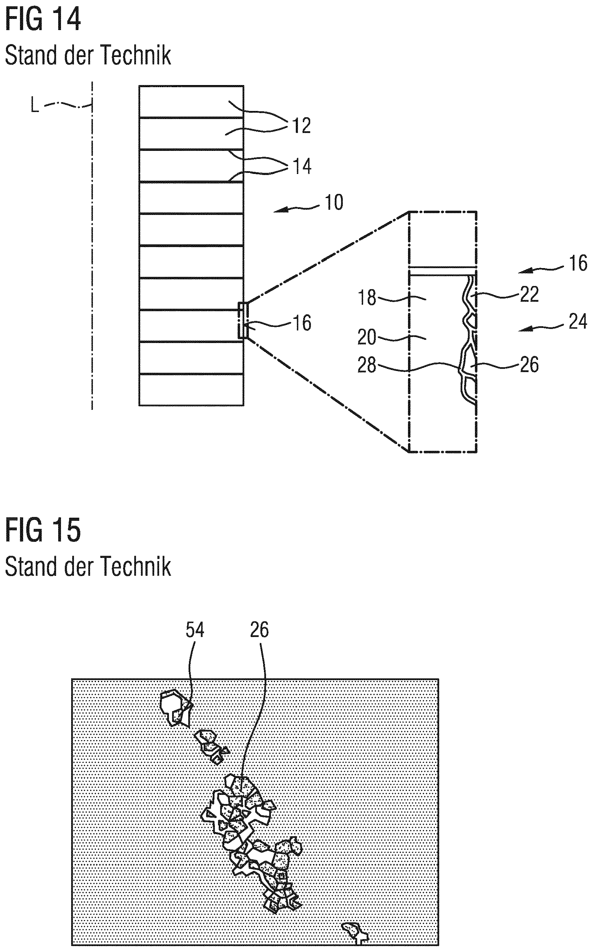

Fig. 14 und Fig. 15 zeigen schematisch die angesprochene Problematik.

In Fig. 14 ist ein Schichtstapel 10 gezeigt, der eine Mehrzahl an piezoelektrischen Keramikschichten 12 und eine Mehrzahl an elektrisch leitfähigen Innenelektroden 14 aufweist, wobei entlang einer Längsachse L des Schichtstapels 10 jeweils eine Elektrode 14 zwischen zwei Keramikschichten 12 angeordnet ist. Fig. 14 zeigt außerdem einen Bereich einer Oberfläche 16 einer der Keramikschichten 12 in einer vergrößerten Ansicht. In dieser vergrößerten Ansicht ist zu sehen, dass an der Oberfläche 16 die Keramikschicht 12 einen ersten Bereich 18 aufweist, in dem das Material der Keramikschicht 12 als ein polykristallines Gefüge 20, d. h. als geschlossener Kristall, vorliegt. Weiter liegt an der Oberfläche 16 der Keramikschicht 12 ein zweiter Bereich 22 vor, in dem ein piezoelektrisches Keramikmaterial 24 vorhanden ist, das nicht mehr Bestandteil des polykristallinen Gefüges 20 ist, sondern lediglich mechanisch an dem polykristallinen Gefüge 20 anhaftet. Dieses Keramikmaterial 24 bildet somit einen im Bezug auf das polykristalline Gefüge 20 losen Kornverbund 26.

Fig. 15 zeigt eine REM-Aufnahme eines von der Oberfläche 16 der Keramikschicht 12 abgezogenen Kornverbundes 26.

Solche losen Kornverbunde 26 sind zwar nicht mehr Teil des polykristallinen Gefüges 20, haften jedoch mechanisch noch relativ stark am polykristallinen Gefüge 20 an.

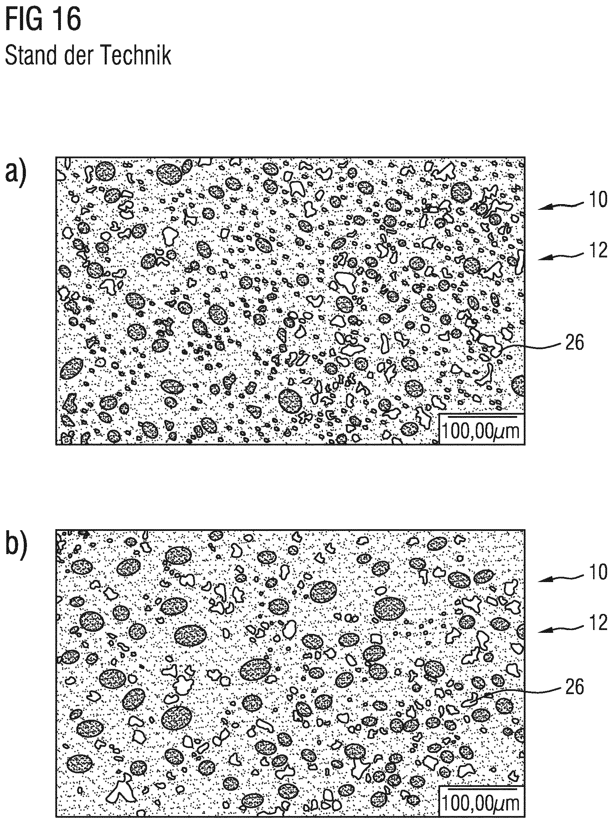

Fig. 16 zeigt dazu in Bild a) eine mikroskopische Aufnahme der Oberfläche 16, wobei die losen Kornverbunde 26 durch helle Bereiche dargestellt sind. Im Bild b) ist die Oberfläche 16 gezeigt, nachdem der Schichtstapel 10 zum Entfernen von Verschmutzungen und Partikeln in einem Lösungsmittelbad ultraschallbehandelt worden ist. Da die elektrischen Feldstärken in der Vergangenheit nicht so hoch waren, war diese Art der Vorbehandlung zur Reinigung des Schichtstapels 10 ausreichend. In Bild b) ist jedoch zu sehen, dass auf der Oberfläche 16 auch weiterhin lose Kornverbunde 26 in großer Anzahl vorhanden sind. Das mechanische Anhaften der Kornverbunde 26 ist demnach so stark, dass übliche Reinigungsverfahren wie beispielsweise Ultraschall die losen Kornverbunde 26 nicht vom Schichtstapel 10 lösen können.

Wie in Fig. 14 zu sehen ist, bilden sich im ungünstigsten Fall zwischen dem polykristallinen Gefüge 20 und dem Kornverbund 26 Pfade 28 aus, die einen elektrisch leitfähigen Pfad 28 bilden können, wenn beispielsweise in diesem Bereich der Oberfläche 16 Feuchtigkeit eindringt.

Dies ist insbesondere nachteilig, wenn der Schichtstapel 10 mit sehr hohen elektrischen Feldstärken beaufschlagt wird, da es dann zu elektrischen Überschlägen in dem Schichtstapel 10 kommen kann.

Die US 2003/0164660 A1 offenbart ein Verfahren zur Herstellung eines piezoelektrischen Teils, das einen piezoelektrischen Schichtstapel umfasst. Im Rahmen der Herstellung des Schichtstapels werden bei einem Schneidevorgang entstehende Teilchen, z.B. durch Ultraschall-Reinigung, entfernt.

Die EP 2 472 619 A1 offenbart ein Verfahren zur Herstellung eines piezoelektrischen Schichtstapels mit verbesserter Haltbarkeit. Hierzu ist vorgesehen, aktive Bereiche der Seitenflächen des Schichtstapels im Vergleich zu den inaktiven Bereichen mit einer raueren Oberfläche zu versehen, wobei auf den aktiven Bereichen eine Außenelektrode aufgebracht wird.

Die US 2006/0124156 A1 beschreibt eine Vorrichtung zur Erzeugung von Partikeln aus druckbeaufschlagtem CO₂ durch Entspannung zur Reinigung einer Oberfläche.

Die DE 10 2013 104 621 A1 offenbart ein Verfahren zur Passivierung eines Bauelements durch Eintauchen in deionisiertes Wasser.

Aufgabe der Erfindung ist es daher, ein Verfahren zur Herstellung eines piezoelektrischen Schichtstapels sowie einen entsprechenden Schichtstapel vorzuschlagen, durch das die vorgenannten Probleme überwunden werden können.

Diese Aufgabe wird mit einem Verfahren zur Herstellung eines piezoelektrischen Schichtstapels gemäß Anspruch 1 gelöst.

Ein piezoelektrischer Schichtstapel, der insbesondere mit einem solchen Verfahren hergestellt worden ist, ist Gegenstand des Anspruchs 7. Vorteilhafte Ausgestaltungen der Erfindung sind Gegenstand der abhängigen Ansprüche.

Bei einem Verfahren zur Herstellung eines piezoelektrischen Schichtstapels werden die folgenden Schritte durchgeführt: In Schritt S1) wird ein Schichtstapel bereitgestellt, der eine Mehrzahl an piezoelektrischen Keramikschichten und eine Mehrzahl an elektrisch leitfähigen Innenelektroden aufweist, wobei entlang einer Längsachse des Schichtstapels jeweils eine Innenelektrode zwischen zwei Keramikschichten angeordnet ist. Die piezoelektrischen Keramikschichten weisen an ihrer Oberfläche einen ersten Bereich auf, in dem ein polykristallines Gefüge vorliegt. Weiter weisen die piezoelektrischen Keramikschichten einen zweiten Bereich auf, in dem an dem polykristallinen Gefüge lediglich mechanisch anhaftendes piezoelektrisches Keramikmaterial vorliegt. In einem Schritt S2) wird das an dem polykristallinen Gefüge lediglich mechanisch anhaftende piezoelektrische Keramikmaterial ohne Beschädigung des polykristallinen Gefüges entfernt.

Die piezoelektrischen Keramikschichten sind neben ihrer Oberfläche auch im Volumen aus dem polykristallinen Gefüge gebildet.

Unter "Oberfläche" soll dabei ein Bereich verstanden werden, der sich etwa 15 µm - 20 µm in das Volumen der Keramikschichten des Schichtstapels hinein erstreckt.

Durch ein solches Herstellungsverfahren wird die Oberfläche des Schichtstapels von den losen Kornverbunden befreit, ohne jedoch mechanische Beschädigungen an dem polykristallinen Gefüge zu verursachen, die ihrerseits wieder zur Bildung von neuen losen Kornverbunden führen könnten. Dadurch existieren bzw. entstehen im Betrieb keine losen Korngrenzen mehr, die als niederohmiger Pfad einen Ausfall des Schichtstapels als Bauteil verursachen könnten.

Vorzugsweise werden bei dem beschriebenen Verfahren die folgenden Schritte durchgeführt:
S2a) Bereitstellen eines durch Druckbeaufschlagung verflüssigten Gases;
S2b) Entspannen des Gases derart, dass sich Mikrokristalle bilden;
S2c) Ausrichten und Beschleunigen der Mikrokristalle zu einer gerichteten Strömung;
S2d) Beaufschlagen einer Oberfläche des Schichtstapels mit der gerichteten Strömung.

Die Beschleunigung in Schritt S2c) erfolgt dabei vorzugsweise über Zufuhr von Druckluft zu den sich bildenden bzw. gebildeten Mikrokristallen.

Beim Beaufschlagen der Oberfläche des Schichtstapels mit der Strömung aus Mikrokristallen wirkt vorteilhaft eine mechanische Energie auf das mechanisch anhaftende piezoelektrische Keramikmaterial, d. h. den Kornverbund, welche ausreicht, um dieses nur mechanisch anhaftende Keramikmaterial von dem polykristallinen Gefüge zu entfernen. Die Verwendung von Mikrokristallen, die sich aus einem entspannten, zuvor durch Druckbeaufschlagung verflüssigten Gas, gebildet haben, haben den Vorteil, dass die Mikrokristalle nach Kontakt der Oberfläche mit dem Schichtstapels wieder in den gasförmigen Zustand übergehen und somit keine Rückstände auf der Oberfläche des Schichtstapels zurückbleiben, wie dies beispielsweise bei einem Beaufschlagen der Oberfläche mit Sandpartikeln, Glaspartikeln o. ä. der Fall wäre.

Daher ist es von Vorteil, wenn ein Gas verwendet wird, das bei Standardbedingungen, d. h. Raumtemperatur, insbesondere 20° C, und einem Druck von p=1013 mbar gasförmig ist. Beispielsweise kann daher als verflüssigtes Gas vorteilhaft CO₂, N₂ und/oder ein Edelgas verwendet werden.

Vorzugsweise wird die Oberfläche des Schichtstapels mit einem Abstand von 1 cm - 10 cm, vorzugsweise 2 cm - 8 cm, vorzugsweise 3 cm - 6 cm, insbesondere 4 cm, zu einer Quelle der Strömung über die Strömung bewegt. Dieser Bereich hat sich in Experimenten als besonders vorteilhaft erwiesen, Denn bei einem zu geringen Abstand sind die Mikrokristalle in der Strömung noch nicht ausreichend beschleunigt, um das mechanisch anhaftende piezoelektrische Keramikmaterial vollständig von der Oberfläche des Schichtstapels entfernen zu können. Ein zu grOßer Abstand dagegen resultiert in einer zu stark aufgefächerten Strömung. Vorzugsweise hat die Strömung dort, wo sie auf die Oberfläche des Schichtstapels auftrifft, eine Breite, die der Breite des Schichtstapels entspricht.

Dazu ist es ebenfalls vorteilhaft, wenn die Strömung einen Druck von 2 bar - 25 bar, insbesondere 5 bar - 20 bar, mehr insbesondere 10 bar - 16 bar, aufweist.

Bevorzugte Beaufschlagungszeiten bewegen sich in einem Bereich zwischen 2 Sekunden und 15 Sekunden, um das mechanisch anhaftende piezoelektrische Keramikmaterial vollständig von der Oberfläche des Schichtstapels entfernen zu können.

"Vollständig" bedeutet dabei, dass mehr als 80 % der Oberfläche der Keramikschicht frei ist von Keramikmaterial, das lediglich mechanisch an dem polykristallinen Gefüge anhaftet. Das heißt, dass an weniger als 20 % der Oberfläche der Keramikschichten das lediglich mechanisch anhaftende piezoelektrische Keramikmaterial vorliegt.

Vorzugsweise wird nach Entfernen des an dem polykristallinen Gefüge lediglich mechanisch anhaftenden piezoelektrischen Keramikmaterials die Oberfläche des Schichtstapels in einem Schritt S3) deionisiert. Insbesondere erfolgt dies durch Abblasen mit ionisierter Luft. Alternativ oder zusätzlich kann jedoch der Schichtstapel auch in einem Lösungsmittelbad mit Ultraschall beaufschlagt werden. Das Deionisieren hat den Vorteil, dass dabei die Oberfläche des Schichtstapels ladungsfrei und somit homogen wird.

Vorteilhaft wird die Oberfläche des Schichtstapels nach dem Deionisieren in einem Schritt S4) passiviert. Dazu wird beispielsweise ein Passivierungslack aufgetragen. Die Passivierung der Oberfläche des Schichtstapels hat den Vorteil, dass elektrische Überschläge im Betrieb des Schichtstapels vermieden werden können.

Ein piezoelektrischer Schichtstapel, der insbesondere mit einem wie oben beschriebenen Verfahren hergestellt worden ist, weist eine Mehrzahl an aus piezoelektrischem Keramikmaterial gebildeten Keramikschichten und eine Mehrzahl an elektrisch leitfähigen Innenelektroden auf. Entlang einer Längsachse des Schichtstapels ist jeweils eine Innenelektrode zwischen zwei Keramikschichten angeordnet. Die piezoelektrischen Keramikschichten weisen an ihrer Oberfläche einen ersten Bereich, in dem ein polykristallines Gefüge vorliegt, und einen zweiten Bereich auf, in dem an dem polykristallinen Gefüge lediglich mechanisch anhaftendes piezoelektrisches Keramikmaterial vorliegt. An weniger als 20 % der Oberfläche der Keramikschichten liegt das lediglich mechanisch anhaftende piezoelektrische Keramikmaterial vor.

Ein solcher piezoelektrischer Schichtstapel hat den Vorteil, dass auch bei Beaufschlagung des Schichtstapels mit sehr hohen Feldstärken in nur geringem Maße mit elektrischen Überschlägen durch unerwünschte leitfähige Pfade, die sich zwischen dem polykristallinen Gefüge und den losen Kornverbunden an der Oberfläche des polykristallinen Gefüges ausbilden, zu rechnen ist. Denn diese losen Kornverbunde sind in dem piezoelektrischen Schichtstapel weitgehend nicht mehr vorhanden.

Vorteilhaft weisen die piezoelektrischen Keramikschichten eine mittlere Rauheit von 0,5 µm - 3 µm, insbesondere 1 µm - 2 µm, auf. Die Rauheit in diesem Bereich hat den Vorteil, dass nachfolgend auf die Oberfläche des Schichtstapels aufzubringende Materialschichten besonders gut an dem Schichtstapel haften können.

Vorzugsweise ist an der Oberfläche der Keramikschichten eine Passivierungsschicht, insbesondere ein Passivierungslack angeordnet.

Vorteilhafte Ausgestaltungen der Erfindung werden nachfolgend anhand der beigefügten Zeichnungen näher erläutert. Darin zeigt:
- Fig. 1: ein Flussdiagramm, das schematisch die Schritte darstellt, welche bei einem Verfahren zur Herstellung eines piezoelektrischen Schichtstapels durchgeführt werden;
- Fig. 2: eine erste Möglichkeit zum Deionisieren des Schichtstapels nach Beaufschlagung mit der gerichteten Strömung;
- Fig. 3: eine zweite Möglichkeit zur Deionisierung des Schichtstapels nach Beaufschlagung mit der gerichteten Strömung;
- Fig. 4: den gemäß Fig. 6 bzw. Fig. 7 deionisierten Schichtstapel, der an seiner Oberfläche eine Passivierungsschicht aufweist;
- Fig. 5: ein Flussdiagramm, welches schematisch Teilschritte darstellt, die in dem Verfahren gemäß Fig. 1 durchgeführt werden;
- Fig. 6: ein durch Druckbeaufschlagung verflüssigtes Gas, wie es in dem Verfahren gemäß Fig. 1 verwendet wird;
- Fig. 7: das druckbeaufschlagte verflüssigte Gas aus Fig. 6, das durch Öffnen des Gasbehälters entspannt und durch eine Ausrichtvorrichtung zu einer gerichteten Strömung ausgerichtet wird;
- Fig. 8: einen piezoelektrischen Schichtstapel, der mit der gemäß Fig. 7 gebildeten Strömung beaufschlagt wird;
- Fig. 9: eine mikroskopische Aufnahme eines Längsschnittes durch einen Schichtstapel, bei dem das Verfahren gemäß Fig. 1 nicht durchgeführt worden ist;
- Fig. 10: eine REM-Aufnahme des Schichtstapels gemäß Fig. 9;
- Fig. 11: eine mikroskopische Aufnahme eines Längsschnittes durch einen Schichtstapel, bei dem das Verfahren gemäß Fig. 1 durchgeführt worden ist;
- Fig. 12: eine REM-Aufnahme des Schichtstapels gemäß Fig. 11;
- Fig. 13: einen Vergleich mikroskopischer Aufnahmen von Schichtstapeln, die a) unbehandelt, b) mit einem Ultraschallbad vorgereinigt, c) mit dem gemäß Fig. 1 beschriebenen Verfahren gereinigt worden sind;
- Fig. 14: einen Schichtstapel nach dem Stand der Technik;
- Fig. 15: eine REM-Aufnahme einer losen, von dem Schichtstapel aus Fig. 14 abgelösten, Kornschicht; und
- Fig. 16: einen Vergleich mikroskopischer Aufnahmen eines a) unbehandelten, b) mit einem Ultraschallbad vorgereinigten Schichtstapels.

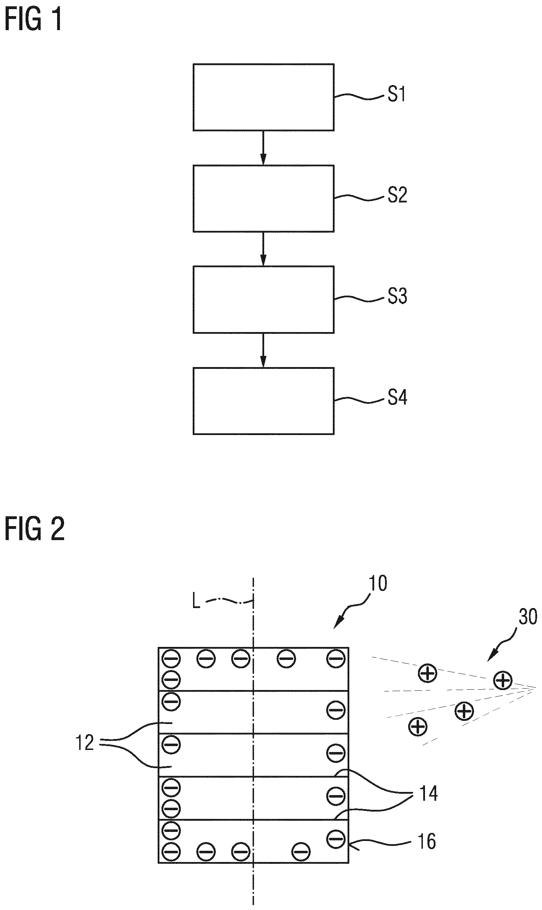

Fig. 1 zeigt ein Flussdiagramm, das schematisch Verfahrensschritte zur Herstellung eines piezoelektrischen Schichtstapels 10 darstellt.

Dabei wird im Schritt S1) ein Schichtstapel 10 bereitgestellt, der aus einer Mehrzahl an piezoelektrischen Keramikschichten 12 und einer Mehrzahl an elektrisch leitfähigen Innenelektroden 14 aufgebaut ist, welche sich in Richtung einer Längsachse L des Schichtstapels 10 abwechseln. Die Keramikschichten 12 weisen an ihrer Oberfläche 16 einen ersten Bereich 18 auf, in dem ein Keramikmaterial 24 als polykristallines Gefüge 20 vorliegt, sowie einen zweiten Bereich 22, in dem das Keramikmaterial 24 an dem polykristallinen Gefüge 20 lediglich mechanisch anhaftet, jedoch keinen Teil des polykristallinen Gefüges 20 bildet.

In Schritt S2) wird dann das lediglich mechanisch anhaftende Keramikmaterial 24 von dem polykristallinen Gefüge 20 entfernt, und zwar derart, dass das polykristalline Gefüge 20 nicht beschädigt wird.

Durch das Entfernen des Keramikmaterials 24 von dem polykristallinen Gefüge 20 der Keramikschichten 12 kann sich die Oberfläche 16 der Keramikschicht elektrostatisch aufladen, was für nachfolgende Behandlungsschritte des Schichtstapels 10 ungünstig sein kann. Deshalb wird in Schritt S3) die Oberfläche 16 des Schichtstapels 10 deionisiert.

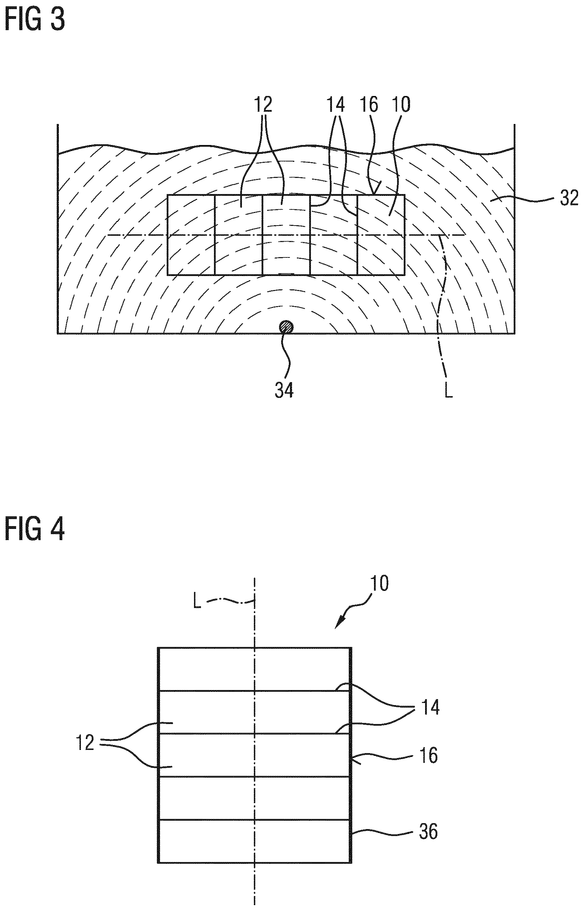

Fig. 2 und Fig. 3 zeigen dazu schematisch Momentaufnahmen von möglichen Deionisierungsverfahren. In Fig. 2 wird beispielsweise zum Deionisieren die Oberfläche 16 des Schichtstapels 10, die durch das Entfernen des Keramikmaterials 24 elektrostatisch aufgeladen ist, mit ionisierter Luft 30 abgeblasen. Alternativ oder zusätzlich kann auch, wie in Fig. 3 gezeigt, der Schichtstapel 10 in einem Lösungsmittelbad 32 mit Ultraschall 34 beaufschlagt werden.

Um elektrische Überschläge im Betrieb des Schichtstapels 10 zu vermeiden, wird nach dem Deionisieren der Oberfläche 16 des Schichtstapels 10 die Oberfläche 16 des Schichtstapels 10 in einem Schritt S4) passiviert, beispielsweise indem ein Passivierungslack 36 auf die Oberfläche 16 aufgetragen wird. Ein solcher mit einem Passivierungslack 36 behandelter Schichtstapel 10 ist in Fig. 4 gezeigt.

S3) und S4) sind optionale Verfahrensschritte bei dem Verfahren zur Herstellung eines piezoelektrischen Schichtstapels 10, die abhängig von der nachfolgenden Weiterbehandlung des Schichtstapels 10 durchgeführt werden können oder nicht.

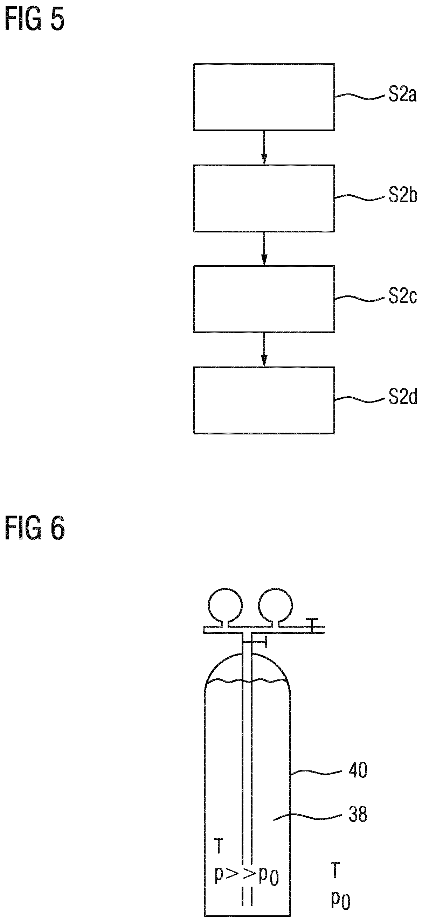

Fig. 5 zeigt ein Flussdiagramm, das schematische Teilschritte darstellt, welche in Schritt S2) zum Entfernen des Keramikmaterials 24 von dem polykristallinen Gefüge 20 durchgeführt werden können.

Beispielsweise kann das lose Keramikmaterial 24 durch mechanisches Strahlen von dem polykristallinen Gefüge 20 entfernt werden.

Beispielsweise wird dazu in Schritt S2a) ein Gas 38 bereitgestellt, das durch Druckbeaufschlagung verflüssigt worden ist. Fig. 6 zeigt hierzu das verflüssigte Gas 38, das in einem Druckbehältnis 40 bereitgestellt wird. Das Druckbehältnis 40 sowie das darin angeordnete verflüssigte Gas 38 haben eine Temperatur T, die der Umgebungstemperatur T, beispielsweise der Raumtemperatur, entspricht. Jedoch ist der Druck p in dem Gas 38 deutlich höher als der Umgebungsdruck p₀. Durch diese Druckbeaufschlagung mit dem hohen Druck p liegt das Gas 38 in dem Druckbehältnis 40 als Flüssigkeit vor.

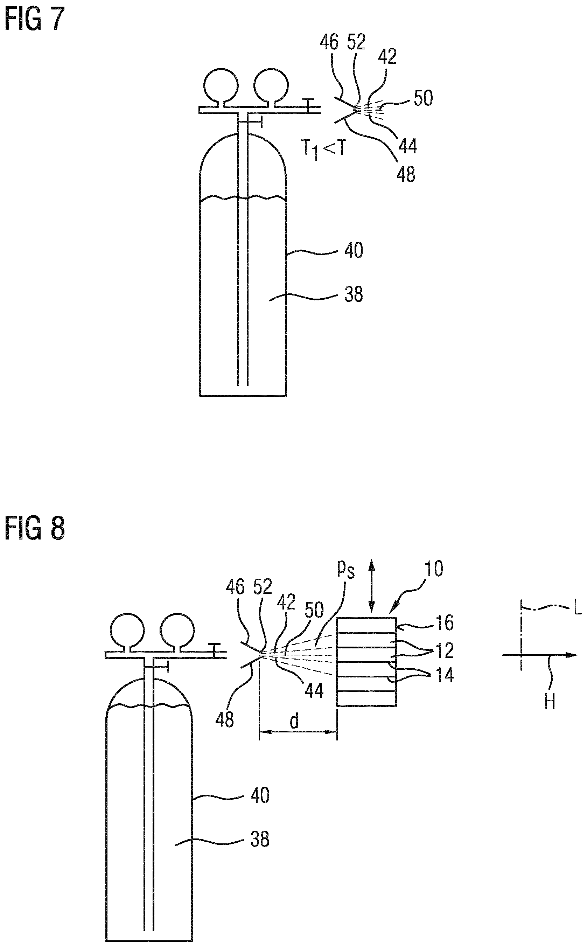

In Schritt S2b) wird das Gas 38 dann entspannt. Dazu wird beispielsweise, wie in Fig. 7 schematisch dargestellt ist, das Druckbehältnis 40 geöffnet, so dass das Gas 38 in die Umgebung außerhalb des Druckbehältnisses 40 entweichen kann, wo ein deutlich niedriger Druck p₀ herrscht als im Druckbehältnis 40. Beim Entspannen des Gases 38 vergrößert sich dessen Volumen, wozu das Gas 38 Volumenarbeit gegen die Umgebung verrichten muss. Die Energie hierzu wird dem Gas selbst entnommen, wodurch es von der Umgebungstemperatur T auf eine Temperatur T₁ abkühlt, die deutlich niedriger ist als die Umgebungstemperatur T. Beim Abkühlen kondensiert das Gas 38 durch den Energieverlust zu einem Feststoff 42, insbesondere in der Form von Mikrokristallen 44.

Um das aus dem Druckbehältnis 40 austretende, expandierende Gas 38 und die sich dabei bildenden Mikrokristalle 44 als mechanische Partikel zum Behandeln der Oberfläche 16 des Schichtstapels 10 nutzen zu können, wird das expandierende Gas 38 in einem Schritt S2c) ausgerichtet, beispielsweise durch Verwendung einer Ausrichtungsvorrichtung 46, z. B. einer Blende 48, so dass eine gerichtete Strömung 50 aus den sich bildenden Mikrokristallen 44 entsteht. Schematisch sind die Schritte S2b) und S2c) in einer Momentaufnahme des Verfahrens in Fig. 7 gezeigt.

In einem Schritt S2d) wird dann die Oberfläche 16 des Schichtstapels 10 mit der gerichteten Strömung 50 beaufschlagt. In einer schematischen Momentaufnahme ist dies in Fig. 8 gezeigt.

Dabei wird die gerichtete Strömung 50 stationär gehalten, d. h. eine Quelle 52, in Fig. 8 der Austrittspunkt der Mikrokristalle 44 aus der Ausrichtungsvorrichtung 46, verändert die Position im Raum nicht. Um die gesamte Oberfläche 16 des Schichtstapels 10 mit der gerichteten Strömung 50 beaufschlagen zu können, wird jedoch der Schichtstapel 10, wie in Fig. 8 durch den Doppelpfeil dargestellt, über die gerichtete Strömung 50 bewegt. Dies kann beispielsweise so erfolgen, dass die Längsachse L des Schichtstapels 10 exakt senkrecht zu einer Hauptströmungsrichtung H der gerichteten Strömung 50 angeordnet ist, es ist jedoch auch möglich, dass ein geneigter Winkel zwischen 0° und 90° zwischen der Längsachse L und der Hauptströmungsrichtung H angenommen wird.

Vorteilhaft wird der Schichtstapel dabei kontinuierlich um seine Längsachse L gedreht.

Ein Abstand d zwischen der Quelle 52 der gerichteten Strömung 50 und der Oberfläche 16 des Schichtstapels 10 liegt vorteilhaft in einem Bereich zwischen 1 cm - 10 cm. Besonders vorteilhaft ist ein Abstand d von 3 cm bis 6 cm. Je näher die Quelle 52 dabei an der Oberfläche 16 angeordnet ist, umso mehr Mikrokristalle 44 schlagen auf einem definierten Flächenbereich der Oberfläche 16 ein, d. h. eine umso höhere Kraft pro Fläche wirkt auf die Oberfläche 16 in diesem Flächenbereich. Wird dieser Abstand d zu nahe gewählt, kann dies zu einer Beschädigung des polykristallinen Gefüges 20 führen.

Gleiche Überlegungen sind anzustellen bezüglich des Druckes pₛ, mit dem die gerichtete Strömung 50 auf die Oberfläche 16 des Schichtstapels 10 auftrifft. Ist der Druck pₛ zu gering, kann das lose Keramikmaterial 24 nicht vollständig von dem polykristallinen Gefüge 20 gelöst werden. Ein optimaler Druckbereich für den Druck pₛ liegt daher zwischen 2 bar und 25 bar, insbesondere 10 bar bis 16 bar.

Als eine bevorzugte Strahlungszeit, in der die Oberfläche 16 mit der gerichteten Strömung 50 beaufschlagt wird, ist ein Bereich zwischen 2 Sekunden und 15 Sekunden ermittelt worden. Diese Zeit reicht dazu aus, das lose Keramikmaterial 24 von der Oberfläche 16 des Schichtstapels 10 zu entfernen.

Kommerziell in Druckbehältnissen 40 erhältliche Gase, die in dem Verfahren zur Herstellung des piezoelektrischen Schichtstapels 10 verwendet werden können, sind beispielsweise CO₂, N₂ und/oder Edelgase wie beispielweise Argon. Sie haben allesamt den Vorteil, dass sie einerseits ungiftig sind und andererseits bei Standardbedingungen gasförmig sind, so dass sie nach Kontakt mit der Oberfläche 16 des Schichtstapels 10 wieder in den gasförmigen Zustand übergehen und sich von der Oberfläche 16 des Schichtstapels 10 verflüchtigen. Dadurch entstehen keinerlei Rückstände durch den verwendeten Feststoff 42, der zum Behandeln der Oberfläche 16 des Schichtstapels 10 verwendet wird.

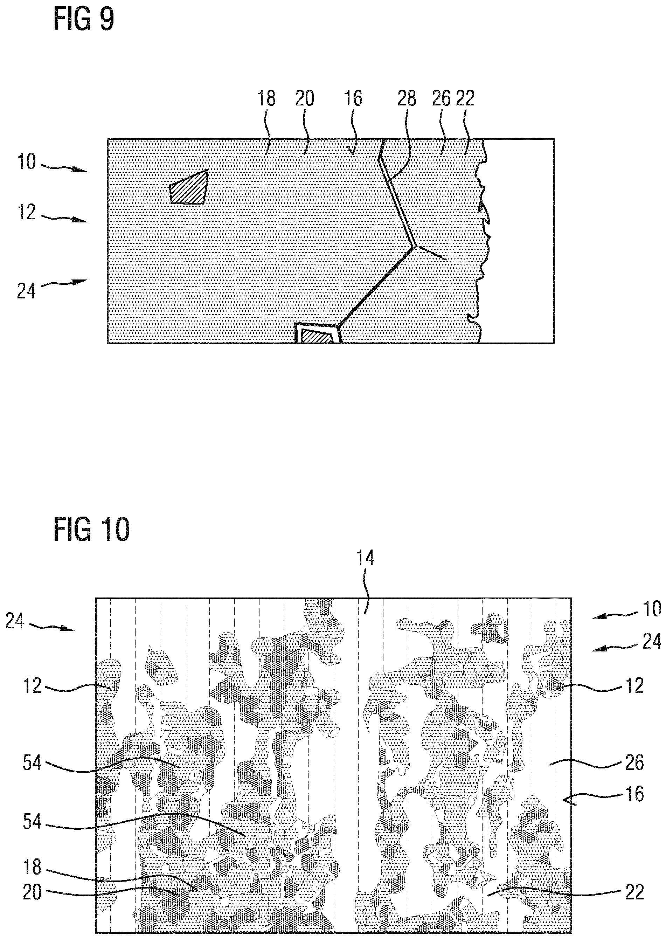

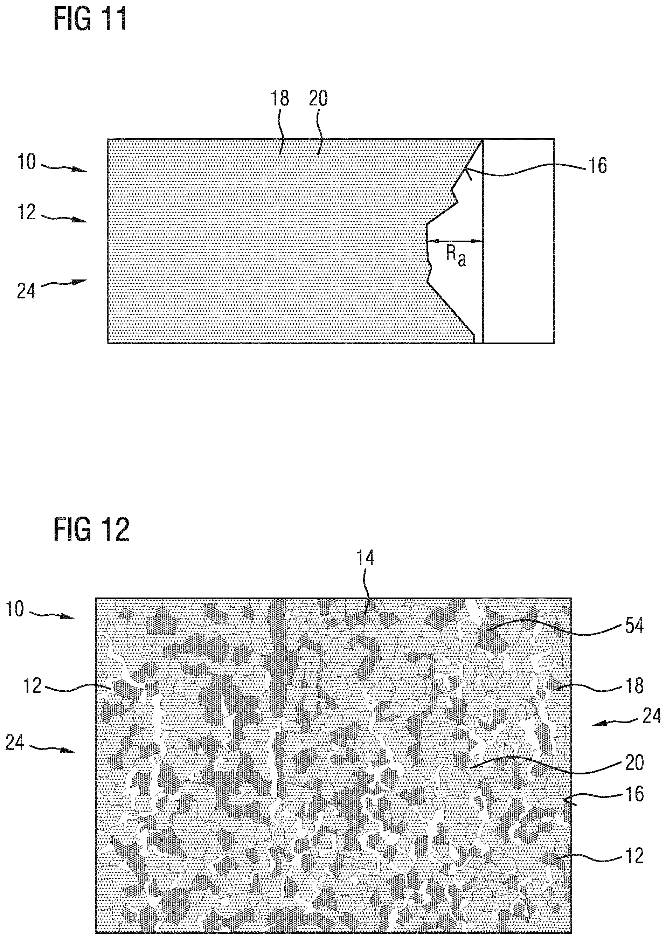

Fig. 9 bis Fig. 12 zeigen Aufnahmen von Oberflächen 16 von Schichtstapeln 10, die einerseits nicht mit dem beschriebenen Verfahren behandelt worden sind (Fig. 9 und Fig. 10), und andererseits mit dem Verfahren wie beschrieben behandelt worden sind (Fig. 11, Fig. 12).

Fig. 9 und Fig. 11 zeigen dabei jeweils eine mikroskopische Aufnahme eines Längsschnittes des Schichtstapels 10, während Fig. 10 und Fig. 12 jeweils eine REM-Aufnahme der Oberfläche 16 des Schichtstapels 10 gemäß Fig. 9 bzw. Fig. 11 zeigen.

In Fig. 9 ist, durch die Pfeile gekennzeichnet, zu erkennen, dass sich loses Keramikmaterial 24 an dem polykristallinen Gefüge 20 befindet.

In Fig. 10 stellt sich dieses lose Keramikmaterial 24 durch die unregelmäßige Verteilung von Kristallkörnern 54 an der Oberfläche 16 dar.

In Fig. 11 ist zu erkennen, dass sich an dem polykristallinen Gefüge 20 im Vergleich zu Fig. 9 kein loses Keramikmaterial 24 mehr befindet. In Fig. 12 zeigt sich daher die Oberfläche 16 des mit dem Verfahren behandelten Schichtstapels 10 als eine regelmäßige Struktur aus Kristallkörnern 54. Die mittlere Rauheit Ra bewegt sich bei dem mit dem Verfahren behandelten Schichtstapel 10 dabei im Bereich von 0, 5 µm - 3 µm, was besonders vorteilhaft ist, wenn die Oberfläche 16 des Schichtstapels 10 später mit weiteren Materialien beschichtet werden soll, beispielsweise mit dem Passivierungslack 36.

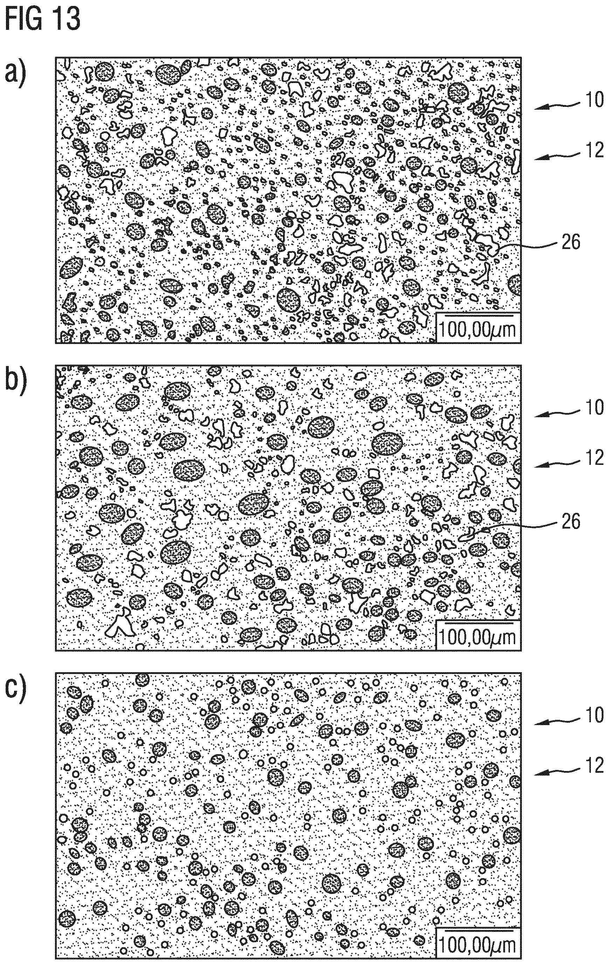

Fig. 13 zeigt zusammenfassend mikroskopische Aufnahmen der Oberfläche 16 von Schichtstapeln 10, die a) vollkommen unbehandelt sind, b) lediglich mit Ultraschall 34 in einem Lösungsmittelbad 32 behandelt worden sind, und c) mit dem oben beschriebenen Verfahren behandelt worden sind, d. h. wobei loses Keramikmaterial 24 durch Beaufschlagen mit verflüssigtem Gas 38 entfernt worden ist.

Das lose Keramikmaterial stellt sich in den Aufnahmen gemäß a), b) und c) als helle Flecke dar. Es ist zu erkennen, dass durch die Ultraschall-Reinigung des Schichtstapels 10 an der Oberfläche 16 kleinere lose Partikel aus Keramikmaterial 24 im Vergleich zu dem unbehandelten Schichtstapel 10 entfernt werden konnten. Probleme im späteren Betrieb des Schichtstapels 10 bringen jedoch nicht die kleineren, durch Ultraschall entfernbaren Partikel, mit sich, sondern die größeren Kornverbunde 26, die, wie in Aufnahme b) zu sehen ist, weiterhin auf der Oberfläche 16 des Schichtstapels 10 verbleiben und somit nicht von dem polykristallinen Gefüge 20 entfernt worden sind. In Aufnahme c) ist dagegen zu erkennen, dass weitgehend sämtliche Partikel, die das lose Keramikmaterial 24 bilden, entfernt werden konnten. Mehr als 80 % der Oberfläche 16 des Schichtstapels 10 sind somit frei von dem losen Keramikmaterial 24 und an weniger als 20 % der Oberfläche 16 der Keramikschichten 12 liegt das lediglich mechanisch anhaftende piezoelektrische Keramikmaterial 24 vor.

## Patentansprüche

1. Verfahren zur Herstellung eines piezoelektrischen Schichtstapels (10), aufweisend den Schritt:
S1) Bereitstellen eines Schichtstapels (10) mit einer Mehrzahl an piezoelektrischen Keramikschichten (12) und einer Mehrzahl an elektrisch leitfähigen Innenelektroden (14), wobei entlang einer Längsachse (L) des Schichtstapels (10) jeweils eine Innenelektrode (14) zwischen zwei Keramikschichten (12) angeordnet ist, und wobei die piezoelektrischen Keramikschichten (12) an ihrer Oberfläche (16) einen ersten Bereich (18), in dem ein polykristallines Gefüge (20) vorliegt, und einen zweiten Bereich (22) aufweisen, in dem an dem polykristallinen Gefüge (20) lediglich mechanisch anhaftendes piezoelektrisches Keramikmaterial (24) als lose Kornschicht infolge einer vorausgegangen mechanischen Bearbeitung des Schichtstapels (10) vorliegt;
**gekennzeichnet durch** die Schritte:
S2) Entfernen des an dem polykristallinen Gefüge (20) lediglich mechanisch anhaftenden piezoelektrischen Keramikmaterials (24) ohne Beschädigung des polykristallinen Gefüges (20) durch
S2a) Bereitstellen eines durch Druckbeaufschlagung verflüssigten Gases (38);
S2b) Entspannen des Gases (38) derart, dass sich Mikrokristalle (44) bilden;
S2c) Ausrichten der Mikrokristalle (44) zu einer gerichteten Strömung (50);
S2d) Beaufschlagen einer Oberfläche (16) des Schichtstapels (10) mit der gerichteten Strömung (50).

2. Verfahren nach Anspruch 1,
**dadurch gekennzeichnet, dass** als verflüssigtes Gas (38) CO₂ und/oder N₂ und/oder ein Edelgas verwendet wird.

3. Verfahren nach einem der Ansprüche 1 oder 2,
**dadurch gekennzeichnet, dass** die Oberfläche (16) des Schichtstapels (10) mit einem Abstand (d) von 1 cm bis 10 cm, vorzugsweise 2 cm bis 8 cm, vorzugsweise 3 cm bis 6 cm, insbesondere 4 cm, zu einer Quelle (52) der Strömung (50) über die Strömung (50) bewegt wird.

4. Verfahren nach einem der Ansprüche 1 bis 3,
**dadurch gekennzeichnet, dass** die Strömung (50) einen Druck (pₛ) von 2 bar bis 25 bar, insbesondere 5 bar bis 20 bar, insbesondere 10 bar bis 16 bar, insbesondere 14 bar, aufweist.

5. Verfahren nach einem der Ansprüche 1 bis 4,
**dadurch gekennzeichnet, dass** nach Entfernen des an dem polykristallinen Gefüge (20) lediglich mechanisch anhaftenden piezoelektrischen Keramikmaterials (24) die Oberfläche (16) des Schichtstapels (10) in einem Schritt S3) deionisiert wird, insbesondere durch Abblasen mit ionisierter Luft (30) und/oder durch Beaufschlagen mit Ultraschall (34) in einem Lösungsmittelbad (32).

6. Verfahren nach Anspruch 5,
**dadurch gekennzeichnet, dass** die Oberfläche (16) des Schichtstapels (10) nach dem Deionisieren in einem Schritt S4) passiviert wird, insbesondere durch Auftragen eines Passivierungslacks (36).

7. Piezoelektrischer Schichtstapel (10), insbesondere hergestellt mit einem Verfahren nach einem der Ansprüche 1 bis 6, aufweisend eine Mehrzahl an aus piezoelektrischem Keramikmaterial (24) gebildeten Keramikschichten (12) und eine Mehrzahl an elektrisch leitfähigen Innenelektroden (14), wobei entlang einer Längsachse (L) des Schichtstapels (10) jeweils eine Innenelektrode (14) zwischen zwei Keramikschichten (12) angeordnet ist, wobei die piezoelektrischen Keramikschichten (12) an ihrer Oberfläche (16) einen ersten Bereich (18), in dem ein polykristallines Gefüge (20) vorliegt, und einen zweiten Bereich (22) aufweisen, in dem an dem polykristallinen Gefüge (20) lediglich mechanisch anhaftendes piezoelektrisches Keramikmaterial (24) vorliegt, **dadurch gekennzeichnet, dass** an weniger als 20 % der Oberfläche (16) der Keramikschichten (12) das lediglich mechanisch anhaftende piezoelektrische Keramikmaterial (24) vorliegt.

8. Piezoelektrischer Schichtstapel (10) nach Anspruch 7, **dadurch gekennzeichnet, dass** die piezoelektrischen Keramikschichten (12) eine mittlere Rauheit (Ra) von 0,5 µm bis 3 µm, insbesondere 1 µm bis 2 µm, aufweisen.

9. Piezoelektrischer Schichtstapel (10) nach einem der Ansprüche 7 oder 8,
**dadurch gekennzeichnet, dass** an der Oberfläche (16) der Keramikschichten (12) eine Passivierungsschicht, insbesondere ein Passivierungslack (36), angeordnet ist.

## Claims

1. Method for the production of a piezoelectric layer stack (10), having the step of:
S1) providing a layer stack (10) having a plurality of piezoelectric ceramic layers (12) and a plurality of electrically conductive inner electrodes (14), wherein, along a longitudinal axis (L) of the layer stack (10), each inner electrode (14) is arranged between two ceramic layers (12), and wherein the surface (16) of the piezoelectric ceramic layers (12) has a first region (18) with a polycrystalline structure (20) and a second region (22) with piezoelectric ceramic material (24), as loose particle layer as a result of a prior mechanical processing of the layer stack (10), adhering merely mechanically to the polycrystalline structure (20) ;
**characterized by** the steps of:
S2) removing the piezoelectric ceramic material (24) adhering merely mechanically to the polycrystalline structure (20), without damaging the polycrystalline structure (20), by S2a) providing a gas (38) that has been liquefied by compression;
S2b) expanding the gas (38) such that microcrystals (44) form;
S2c) orienting the microcrystals (44) to give an oriented flow (50) ;
S2d) applying the oriented flow (50) to a surface (16) of the layer stack (10).

2. Method according to Claim 1,
**characterized in that** CO₂ and/or N₂ and/or a noble gas is used as the liquefied gas (38).

3. Method according to either of Claims 1 and 2,
**characterized in that** the surface (16) of the layer stack (10) is moved across the flow (50) at a distance (d) of 1 cm to 10 cm, preferably 2 cm to 8 cm, preferably 3 cm to 6 cm, in particular 4 cm, from a source (52) of the flow (50).

4. Method according to one of Claims 1 to 3,
**characterized in that** the flow (50) has a pressure (pₛ) of 2 bar to 25 bar, in particular 5 bar to 20 bar, in particular 10 bar to 16 bar, in particular 14 bar.

5. Method according to one of Claims 1 to 4,
**characterized in that**, after removing the piezoelectric ceramic material (24) adhering merely mechanically to the polycrystalline structure (20), the surface (16) of the layer stack (10) is deionized in a step S3), in particular by blasting with ionized air (30) and/or by treatment with ultrasound (34) in a solvent bath (32).

6. Method according to Claim 5,
**characterized in that**, after deionizing, the surface (16) of the layer stack (10) is passivated in a step S4), in particular by application of a passivation lacquer (36).

7. Piezoelectric layer stack (10), in particular produced using a method according to one of Claims 1 to 6,
having a plurality of ceramic layers (12) made of piezoelectric ceramic material (24) and a plurality of electrically conductive inner electrodes (14), wherein, along a longitudinal axis (L) of the layer stack (10), each inner electrode (14) is arranged between two ceramic layers (12), wherein the surface (16) of the piezoelectric ceramic layers (12) has a first region (18) with a polycrystalline structure (20) and a second region (22) with piezoelectric ceramic material (24) adhering merely mechanically to the polycrystalline structure (20), characterized the merely mechanically adhering piezoelectric ceramic material (24) is present on less than 20% of the surface (16) of the ceramic layers (12).

8. Piezoelectric layer stack (10) according to Claim 7,
**characterized in that** the piezoelectric ceramic layers (12) have an average roughness (Ra) of 0.5 µm to 3 µm, in particular 1 µm to 2 µm.

9. Piezoelectric layer stack (10) according to either of Claims 7 and 8,
**characterized in that** a passivation layer, in particular a passivation lacquer (36), is arranged on the surface (16) of the ceramic layers (12).

## Revendications

1. Procédé de fabrication d'un empilement de couches piézoélectriques (10) comprenant l'étape suivante :
S1) la fourniture d'un empilement de couches (10) présentant une pluralité de couches céramiques piézoélectriques (12) et une pluralité d'électrodes intérieures (14) électroconductrices, dans lequel une électrode intérieure (14) est disposée le long d'un axe longitudinal (1) de l'empilement de couches (10) entre deux couches céramiques (12), et dans lequel les couches céramiques piézoélectriques (12) présentent sur leur surface (16) une première zone (18) dans laquelle se trouve une structure polycristalline (20) et une seconde zone (22) dans laquelle se trouve un matériau céramique piézoélectrique (24) adhérant uniquement de façon mécanique à la structure polycristalline (20) sous la forme d'une couche à grains libres suite à un usinage mécanique préalable de l'empilement de couches (10) ; **caractérisé par** les étapes suivantes :
S2) enlèvement du matériau céramique piézoélectrique (24) adhérant uniquement de façon mécanique à la structure polycristalline (20) sans endommager la structure polycristalline (20), par
S2a) fourniture d'un gaz liquéfié par application de pression (38) ;
S2b) détente du gaz (38) de manière à former des microcristaux (44) ;
S2c) orientation des microcristaux (44) suivant un écoulement directionnel (50) ;
S2d) application de l'écoulement directionnel (50) à une surface (16) de l'empilement de couches (10).

2. Procédé selon la revendication 1,
**caractérisé en ce que** du CO₂ et/ou du N₂ et/ou un gaz noble est utilisé en tant que gaz liquéfié (38).

3. Procédé selon l'une des revendications 1 ou 2, **caractérisé en ce que** la surface (16) de l'empilement de couches (10) est déplacée à une distance (d) de 1 cm à 10 cm, de préférence de 2 cm à 8 cm, de préférence de 3 cm à 6 cm, en particulier de 4 cm, vers une source (52) de l'écoulement (50), au-dessus de l'écoulement (50).

4. Procédé selon l'une des revendications 1 à 3,
**caractérisé en ce que** l'écoulement (50) présente une pression (pₛ) de 2 bar à 25 bar, en particulier de 5 bar à 20 bar, en particulier de 10 bar à 16 bar, en particulier de 14 bar.

5. Procédé selon l'une des revendications 1 à 4,
**caractérisé en ce que**, après l'enlèvement du matériau céramique piézoélectrique (24) adhérant uniquement de façon mécanique à la structure polycristalline (20), la surface (16) de l'empilement de couches (10) est désionisée lors d'une étape S3), en particulier par soufflage avec de l'air ionisé (30) et/ou par application d'ultrasons (34) dans un bain de solvant (32) .

6. Procédé selon la revendication 5,
**caractérisé en ce que** la surface (16) de l'empilement de couches (10) est passivée après la désionisation lors d'une étape S4), en particulier par application d'un laque de passivation (36).

7. Empilement de couches piézoélectriques (10), en particulier fabriqué par un procédé selon l'une des revendications 1 à 6, comportant une pluralité de couches céramiques (12) formées de matériau céramique piézoélectrique (24) et une pluralité d'électrodes intérieures (14) électroconductrices, dans lequel une électrode intérieure (14) est disposée le long d'un axe longitudinal (L) de l'empilement de couches (10) entre deux couches céramiques (12), dans lequel les couches céramiques piézoélectriques (12) présentent sur leur surface (16) une première zone (18) dans laquelle se trouve une structure polycristalline (20) et une seconde zone (22) dans laquelle se trouve un matériau céramique piézoélectrique (24) adhérant uniquement de façon mécanique à la structure polycristalline (20), **caractérisé en ce que** le matériau céramique piézoélectrique (24) adhérant uniquement de façon mécanique est présent sur moins de 20% de la surface (16) des couches céramiques (12).

8. Empilement de couches piézoélectriques (10) selon la revendication 7, **caractérisé en ce que** les couches céramiques piézoélectriques (12) présentent une rugosité moyenne (Ra) de 0,5 µm à 3 µm, en particulier de 1 µm à 2 µm.

9. Empilement de couches piézoélectriques (10) selon l'une des revendications 7 ou 8, **caractérisé en ce qu'**une couche de passivation, en particulier une laque de passivation (36), est disposée sur la surface (16) des couches céramiques (12).
